# EUROPEAN PATENT SPECIFICATION

(11) **EP 0 313 199 B1**
(45) Date of publication and mention of the grant of the patent: **01.09.1993**
(21) Application number: 88308178.8
(22) Date of filing: 02.09.1988
(51) Int. Cl.: G02F 1/133, H01L 21/84, H01L 29/78

(54) **Liquid crystal display device**
Flüssigkristall-Anzeigevorrichtung
Dispositif d'affichage à cristal liquide

(30) Priority: 15.10.1987 JP 260694/87
(43) Date of publication of application: 26.04.1989
(73) Proprietor: SHARP KABUSHIKI KAISHA, Osaka 545 (JP)
(72) Inventor: Momose, Hidehiko, Sakurai-shi Nara-ken (JP); Kishi, Kohei, Nara-shi Nara-ken (JP); Urabe, Takayuki, Nara-shi Nara-ken (JP)
(74) Representative: Brown, Kenneth Richard

(56) References cited:
- EP-A- 0 196 915
- EP-A- 0 209 113
- GB-A- 2 050 031

## Description

The present invention relates to a liquid crystal matrix display device which uses thin film transistors (hereinafter referred to as TFT) as address devices.

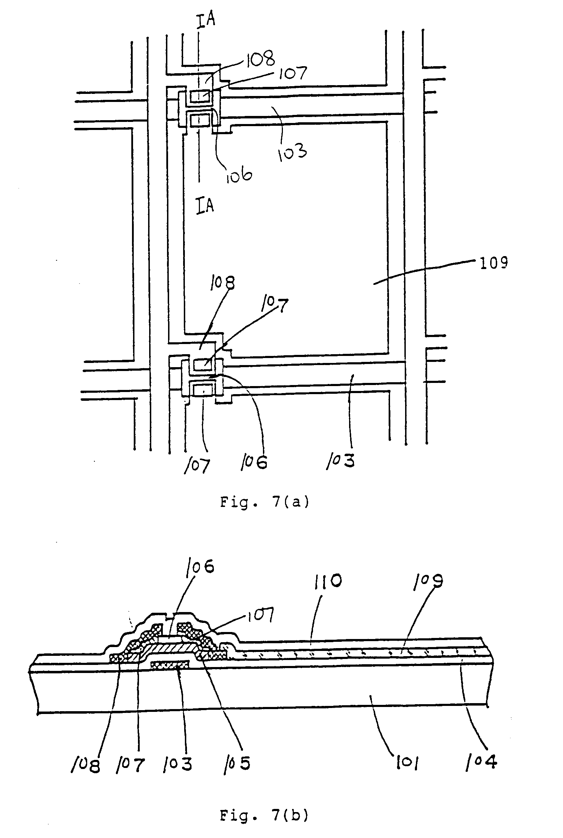

A typical structure of a liquid crystal matrix display device using reverse stagger type TFT as address devices is shown in Figs. 7(a) and 7(b). This liquid crystal display device comprises a gate electrode 103, gate insulation film 104, a-Si film 105, insulation film 106, n⁺ a-Si film 107, source and drain electrodes 108, a picture element electrode 109 and protective film 110 formed in a laminated fashion on an insulating substrate 101. Using glass as the insulating substrate 101 and tantalum (Ta) as the gate electrode 103, when the gate electrode 103 is patterned on the substrate by wet etching, the etchant of the tantalum attacks the glass, resulting in cloudy and/or rough glass surface. No solution to this problem has hitherto been proposed.

The invention disclosed in co-pending European patent application 88305346 (published as EP-A-0,305,030), discussed later herein, is directed to this problem.

The present invention is concerned with, and aims to overcome, the problem of breaks occurring in source bus lines when applying the measures proposed in the above-mentioned co-pending application.

British patent GB 2,050,031 describes liquid crystal displays and a method for their fabrication.

EP 0,209,113 describes liquid crystal display devices with data lines fabricated in a multilayer structure to permit the upper conductor to be formed without step jumps.

According to the present invention there is provided a liquid crystal display device including: an insulating substrate a surface of which carries : a plurality of row and column electrodes, said column electrodes having a predetermined width; a plurality of thin film transistors formed at the intersections of the row and column electrodes and each connected to the row electrode and the column electrode which cross at the respective intersection; thin metallic film portions formed along and under the column electrodes between the row electrodes; and a plurality of picture element electrodes, each connected to a respective said thin film transistor so as to be addressable thereby; characterised in that said device includes an insulating film formed on said insulating substrate, said row and column electrodes, said thin film transistors and said picture element electrodes being formed on said insulating film; and in that both ends of each of said thin metallic film portions are terminated by projections having widths smaller than said predetermined width of the column electrodes.

These projections permit the source bus line to overlap the thin metallic film portions in larger areas, thus inhibiting breaks forming in the source bus line.

Reference will now be made to the accompanying drawings, in which:-
Fig. 1 is a plan view of the substrate of a liquid crystal display device disclosed in published co-pending European application EP-A-0,305,030;
Fig. 2(a) is a sectional view of the substrate of Fig. 1, taken along the line IIA-IIA;
Fig. 2(b) is a sectional view of the substrate of Fig. 1, taken along the line IIB-IIB;
Fig. 2(c) is a sectional view of the substrate of Fig. 1, taken along the line IIC-IIC;
Fig. 3 is a plan view of the substrate of a liquid crystal display device in accordance with the present invention;
Fig. 4(a) is a sectional view of the substrate of Fig. 3, taken along the line IIIA-IIIA;
Fig. 4(b) is a sectional view of the substrate of Fig. 3, taken along the line IIID-IIID;
Fig. 4(c) is a sectional view of the substrate of Fig. 3, taken along the line IIIB-IIIB;
Fig. 4(d) is a sectional view of the substrate of Fig. 3, taken along the line IIIC-IIIC;
Fig. 5 shows the end portion of a reinforcing thin film portion of the substrate of Fig. 3;
Fig. 6 illustrates deviation in patterning of the reinforcing thin film portion 11 from the source bus line 8' on the substrate of Fig. 1;
Fig. 7(a) is a plan view of the substrate of a conventional liquid crystal display device; and
Fig. 7(b) is a sectional view of the substrate of Fig. 7(a), taken along the line IA-IA.

A liquid crystal display device will now be described prior to the description of the present invention.

In a liquid crystal color display device, a plurality of transparent electrodes are formed on each of two transparent substrates, and a color filter is provided on either of the two transparent substrates. The two transparent substrates are placed facing each other with a liquid crystal layer therebetween and with the surfaces which carry the transparent electrodes inside. The entire surface of each transparent substrate facing the liquid crystal layer is covered with an orientational film. The space between the orientational films is filled with, say, TN (twisted nematic) liquid crystal. A polarizing plate is provided on the opposite side of each transparent substrate opposite from the liquid crystal layer. In the liquid crystal display device of the above construction, when voltage is applied to the transparent electrodes, the optical characteristic of the liquid crystal where voltage is applied changes so that the liquid crystal transmits or blocks light depending on the direction of the polarizing axis of each polarizing plate. Therefore, color display can be obtained by applying voltage selectively to the transparent electrodes.

In general, the plurality of electrodes on one of the two transparent substrates face and cross those on the other transparent substrate, forming picture elements at the intersections. However, the substrate of the kind of liquid crystal display device to which the present invention relates contains address devices each corresponding to one of the picture elements, arranged in a matrix.

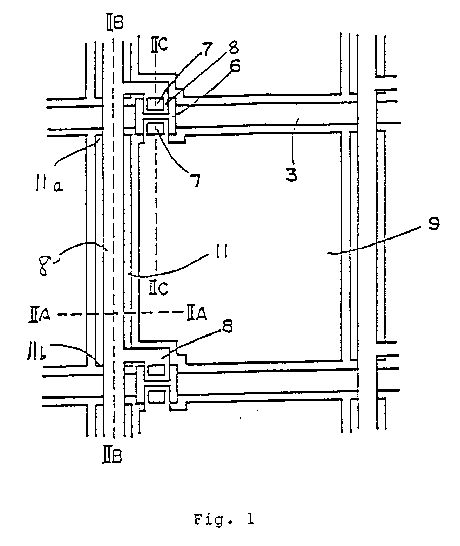

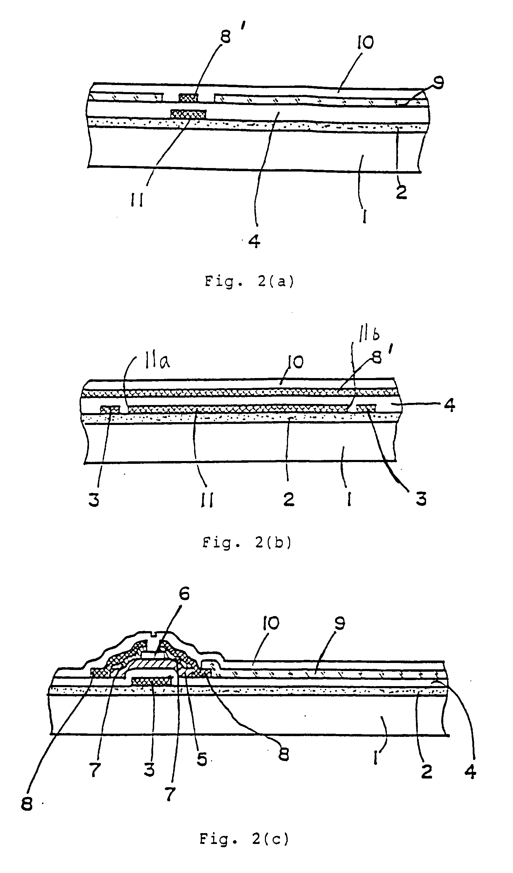

A liquid crystal device claimed in co-pending European patent application EP-A-0,305,030 is now described with reference to Figs. 1, 2(a), 2(b), 2(c) and 6. On an insulating substrate 1 of a glass is formed an insulating film 2 of tantalum pentoxide (Ta₂O₅) about 3000Å thick by Sputtering. Then tantalum (Ta) film about 3000Å thick is formed thereon by sputtering and patternized by photo-etching to form a gate electrode 3 and thin metal film 11 on the same plane. Next, an insulating film 4 of SiNx about 4000Å thick is formed thereon by plasma CVD, and semiconducting layer of amorphous Si (a-Si) about 300Å thick is formed. Further, an insulating layer of SiNx about 2000Å thick is formed thereon. The semiconducting layer and the insulating layer are patternized by photo-etching to form a semiconducting film 5 and an insulating film 6, respectively.

Then, a semiconducting film of n⁺ amorphous Si (n⁺ a-Si) about 400Å thick is formed by plasma CVD and patternized by photo-etching to form a patterned semiconducting film 7. Ti, Mo or W is deposited thereon to a thickness of about 3000Å by sputtering or electron beam evaporation method. The Ti, Mo or W layer thus formed is patternized by photo-etching to form source and drain electrodes 8. A transparent conducting film composed mainly of indium oxide is then formed to a thickness of about 1000Å by sputtering or electron beam evaporation and patternized by photo-etching to form a display picture element electrode 9. Finally, a protective film 10 of SiNx about 5000Å thick is formed by plasma CVD. In the liquid crystal matrix display device thus obtained, thin metal film portions 11 of the same material as the gate electrode 3 are formed in the same plane as the gate electrode 3 under the source bus lines 8'. In the illustrated structure, the thin metal film portions 11 are wider than the source bus line 8', although the former may be of the same width as the latter.

The thin metal film portions 11 protect the insulating substrate 1 from being attacked by the etchant, minimizing the possibility of broken source bus line.

The TFT's which are produced in the above-mentioned process and which serve as address devices are provided one for each of the picture elements of the display device. The picture elements are arranged in matrix.

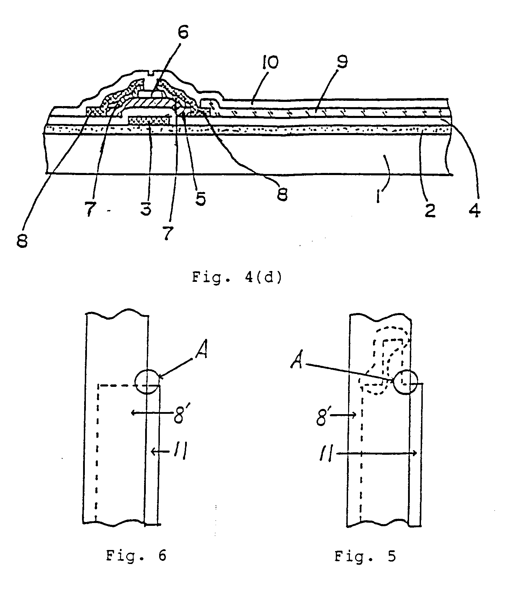

In the liquid crystal display device described above, because of the steps 11a and 11b at the ends of the thin film portions 11 and particularly when the source bus line 8' deviates from the thin film portion 11 in patterning (as shown in Fig. 6), the source bus line 8' may be broken at the point where the source bus line 8' and the thin film 11 form a step.

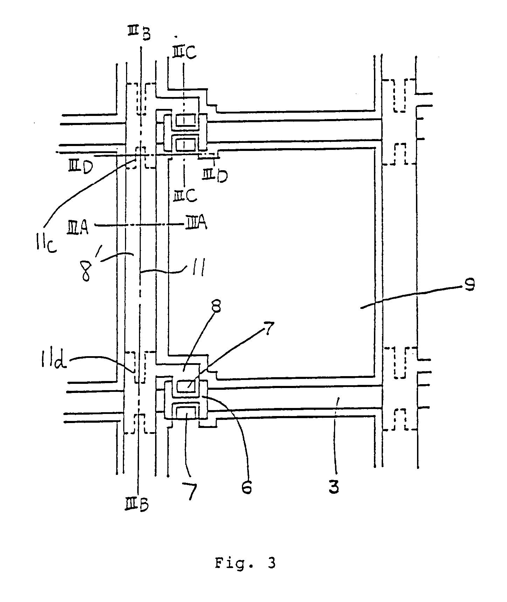

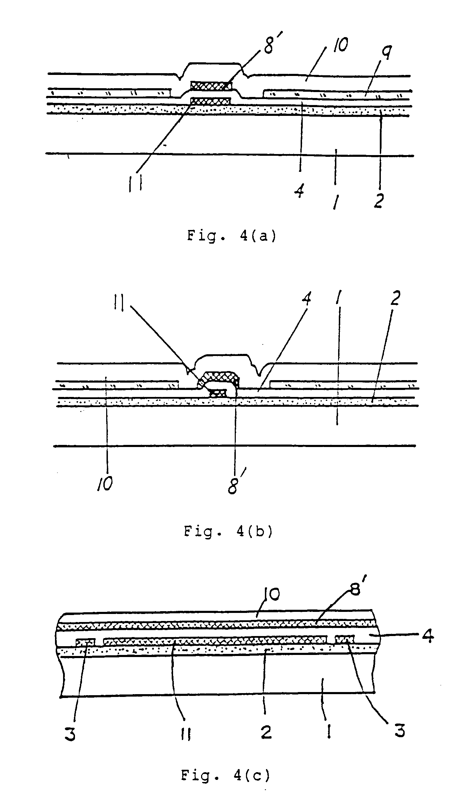

The present invention is directed to this problem, and an embodiment will now be described with reference to Figs. 3, 4(a) through 4(d) and 5 of the drawings. Figs. 4(a) through 4(d) are sectional views of the substrate along the lines IIIA-IIIA, IIID-IIID, IIIB-IIIB and IIIC-IIIC of Fig. 3, respectively. Fig. 5 is an enlarged view of an end of the reinforcing thin film 11.

Insulating film 2 of tantalum pentoxide (Ta₂O₅) is formed to a thickness of about 3000Å by sputtering on an insulating substrate 1 of a glass. Next, a tantalum (Ta) layer about 3000Å thick is formed by sputtering and is patternized by photo-etching to form a gate electrode 3 and source bus line-reinforcing thin film portions 11 in the same plane. The reinforcing thin film portions 11 have projections 11c and 11d on both ends. As described above in relation to the liquid crystal device of Figure 1, the reinforcing thin film 11 also serves to level the source bus line. In the embodiment of Figs. 3 and 4 the reinforcing thin film portions 11 have the same width as the source bus lines 8'.

An insulating film 4 of SiNx is then formed to a thickness of about 4000Å by plasma CVD, and a semiconducting layer of amorphous silicon (a-Si) to a thickness of about 300Å. An insulating layer of SiNx is further formed to a thickness of about 2000Å. The above semiconducting layer and the insulating layer are patternized by photo-etching to form semiconducting film 5 and insulating film 6 respectively. Next, an n⁺ amorphous silicon (n⁺ a-Si) semiconducting film about 400Å thick is formed by plasma CVD, and is patternized by photo-etching to form patternized semiconducting film 7.

Ti, Mo or W is deposited thereon to a thickness of about 3000Å by sputtering or electron beam evaporation, and patternized by photo-etching to form source and drain electrodes 8 and source bus lines 8' simultaneously. A transparent conducting film composed mainly of indium oxide is then formed to a thickness of about 1000Å by sputtering or electron beam evaporation, and patternized by photo-etching to form picture element electrodes 9. Finally, a protective film 10 of SiNx is formed to a thickness of 5000Å by plasma CVD.

In this way, a liquid crystal matrix display panel whose reinforcing thin film portions 11 have end projections is obtained.

The reinforcing thin film portions with projections formed under the source bus line prevents the source bus line 8' from being broken when the pattern of the reinforcing thin film 11 deviates from that of the source bus line 8'. As shown in Fig. 5, if the reinforcing thin film portion 11 deviates from the source bus line 8' in patterning, line breakage would be expected in the area "A". According to the embodiment of the invention, however, the reinforcing thin film portion 11 overlaps in a larger area with the source bus line 8' because of the projection from the reinforcing thin film 11, preventing breakage of the source bus line 8'.

According to the embodiment of the present invention, as mentioned above, the reinforcing thin film portion of a rectangular shape formed under the source bus line has projections on both ends thereof, whereby the resulting liquid crystal matrix display device is substantially free from source bus line breakage which might otherwise be caused by the pattern deviation of the source bus line from the reinforcing thin film under the source bus line.

## Claims

1. A liquid crystal display device including an insulating substrate (1), a surface of which carries: a plurality of row (3) and column (8') electrodes, said column electrodes (8') having a predetermined width; a plurality of thin film transistors formed at the intersections of the row and column electrodes and each connected to the row electrode and the column electrode which cross at the respective intersection; thin metallic film portions (11) formed along and under the column electrodes (8') between the row electrodes (3); and a plurality of picture element electrodes (9), each connected to a respective said thin film transistor so as to be addressable thereby; characterised in that said device includes an insulating film (2) formed on said insulating substrate (1), said row and column electrodes, said thin film transistors and said picture element electrodes being formed on said insulating film; and in that both ends (11a, 11b) of each of said thin metallic film portions (11) are terminated by projections (11c, 11d) having widths smaller than said predetermined width of the column electrodes (8').

2. A liquid crystal display device as claimed in claim 1, wherein said projections (11c, 11d) have a rectangular configuration.

3. A liquid crystal display device as claimed in claim 1 or claim 2, wherein said thin metallic film portions (11) are formed in the same plane as that of the row electrodes (3).

4. A liquid crystal display device as claimed in any preceding claim, wherein the row electrodes (3) and the thin metallic film portions (11) are made of the same material.

5. A liquid crystal display device as claimed in claim 4, wherein the row electrodes (3) and the thin metallic film portions (11) are made of tantalum and have the same thickness.

6. A liquid crystal display device as claimed in any preceding claim, wherein the insulating film (2) is made of tantalum pentoxide.

7. A liquid crystal display device as claimed in claim 4, wherein said thin metallic film portions (11) have the same width as said column electrodes (8') except at said ends (11a,11b).

## Patentansprüche

1. Flüssigkristall-Anzeigevorrichtung mit einem isolierenden Substrat (1) auf dessen Oberfläche folgendes aufgetragen ist:
eine Vielzahl von Zeilenelektroden (3) und Spaltenelektroden (8'), wobei die Spaltenelektroden (8') eine vorbestimmte Breite aufweisen;
eine Vielzahl von an den Kreuzungen der Zeilen- und Spaltenelektroden ausgebildeten Dünnschichttransistoren, von denen jeder mit der Zeilenelektrode und der Spaltenelektrode, die sich an dieser Kreuzung entsprechend schneiden, verbunden ist;
metallische Dünnschichtbereiche (11), die entlang und unter den Spaltenelektroden (8') zwischen den Zeilenelektroden (3) ausgebildet sind; und
eine Vielzahl von Bildelementelektroden (9), von denen jede mit einem entsprechenden besagten Dünnfilmtransistor verbunden ist, so daß sie dadurch adressierbar ist;
**dadurch gekennzeichnet,** daß besagte Vorrichtung eine isolierende Schicht (2) beinhaltet, die auf dem isolierenden Substrat (1) ausgebildet ist, daß besagte Zeilen- und Spaltenelektroden, besagte Dünnschichttransistoren und besagte Bildelementelektroden auf der isolierenden Schicht ausgebildet sind und daß beide Enden (11a, 11b) eines jeden der besagten metallischen Dünnschichtbereiche (11) mit Ansätzen (11c, 11d) enden, die schmaler sind als besagte vorbestimmte Breite der Spaltenelektroden (8').

2. Flüssigkristall-Anzeigevorrichtung nach Anspruch 1, wobei besagte Bereiche (11c, 11d) eine rechtwinklige Anordnung aufweisen.

3. Flüssigkristall-Anzeigevorrichtung nach Anspruch 1 oder 2, wobei besagte metallische Dünnschichtbereiche (11) in der gleichen Ebene ausgebildet sind wie die Zeilenelektroden (3).

4. Flüssigkristall-Anzeigevorrichtung nach einem der vorhergehenden Ansprüche, wobei die Zeilenelektroden (3) und die metallischen Dünnschichtbereiche (11) aus dem gleichen Material bestehen.

5. Flüssigkristall-Anzeigevorrichtung nach Anspruch 4, wobei die Zeilenelektroden (3) und die metallischen Dünnschichtbereiche (11) aus Tantal bestehen und die gleiche Stärke aufweisen.

6. Flüssigkristall-Anzeigevorrichtung nach einem der vorhergehenden Ansprüche, wobei der isolierende Film (2) aus Tantalpentoxid besteht.

7. Flüssigkristall-Anzeigevorrichtung nach Anspruch 4, wobei besagte metallische Dünnschichtbereiche (11) die gleiche Breite aufweisen, wie besagte Spaltenelektroden (8'), ausgenommen an ihren Enden (11a, 11b).

## Revendications

1. Dispositif d'affichage à cristaux liquides comprenant un substrat isolant (1), dont une surface porte: une pluralité d'électrodes de rangée (3) et de colonne (8'), lesdites électrodes de colonne (8') ayant une largeur prédéterminée; une pluralité de transistors à couches minces formés aux intersections des électrodes de rangée et de colonne et reliés chacun à l'électrode de rangée et à l'électrode de colonne qui se croisent à l'intersection respective; des parties (11) de couche mince métallique formées le long des électrodes de colonnes (8') et sous celles-ci, entre les électrodes de rangées (3); et une pluralité d'électrodes (9) d'élément d'image, reliées chacune à un transistor à couches minces respectif de manière à pouvoir être adressée par celui-ci; caractérisé en ce que ledit dispositif comporte une couche isolante (2) formée sur ledit substrat isolant (1), lesdites électrodes de rangée et de colonne, lesdits transistors à couches minces et lesdites électrodes d'élément d'image étant formés sur ladite couche isolante; et en ce que les deux extrémités (11a, 11b) de chacune des parties (11) de couche métallique mince se terminent par des prolongements (11c, 11d) ayant des largeurs inférieures à ladite largeur prédéterminée des électrodes de colonne (8').

2. Dispositif d'affichage à cristaux liquides selon la revendication 1, dans lequel lesdits prolongements (11c, 11d) ont une configuration rectangulaire.

3. Dispositif d'affichage à cristaux liquides selon la revendication 1 ou la revendication 2, dans lequel lesdites parties (11) de couche métallique mince sont formées dans le même plan que celui les électrodes (3) de rangée.

4. Dispositif d'affichage à cristaux liquides selon l'une quelconque des revendications précédentes, dans lequel les électrodes (3) de rangée, et les parties (11) de couche métallique mince sont constituées du même matériau.

5. Dispositif d'affichage à cristaux liquides selon la revendication 4, dans lequel les électrodes (3) de rangée et les parties (11) de couche métallique mince sont constituées de tantale et ont la même épaisseur.

6. Dispositif d'affichage à cristaux liquides selon l'une quelconque des revendications précédentes, dans lequel la couche isolante (2) est constituée de pentoxyde de tantale.

7. Dispositif d'affichage à cristaux liquides selon la revendication 4, dans lequel lesdites parties (11) de couche métallique mince ont la même largeur que lesdites électrodes (8') de colonne, sauf aux extrémités (11a, 11b).
